# EUROPEAN PATENT APPLICATION

(11) **EP 1 107 375 A1**
(43) Date of publication of application: **13.06.2001**
(21) Application number: 00109335.0
(22) Date of filing: 02.05.2000
(51) Int. Cl.: H01R 12/24, H01R 12/08

(54) **Device for clamping a flexible circuit for motor vehicle and motorcycle dashboards**

(30) Priority: 30.11.1999 IT MI990724 U
(71) Applicant: Ecie Electric Components, and Instruments Europe S.R.L., 20125 Milano (IT)
(72) Inventor: Delfi, Luigi Ambrogio, 20125 Milano (IT)
(74) Representative: Cicogna, Franco

(57) **Abstract**

The present invention relates to a device for clamping a flexible circuit, for motor vehicle and motorcycle dashboards, comprising, on a box-like body (1) of a dashboard (2) and the like, at least an insertion element (11), which can be inserted into a corresponding hole (12) of a flexible circuit (10).

The main feature of the invention is that the insertion elelement (11) comprises a tooth element defining an abutment element (21) which can be engaged with the face of the flexible circuit opposed to the insertion face of said tooth element.

## Description

### BACKGROUND OF THE INVENTION

The present invention relates to a device for clamping a flexible circuit, which has been specifically designed for vehicle dashboards and the like.

As is known, for a lot of electric applications and, in particular, for motor vehicle, motorcycle dashboards and the like, are at present used flexible electric circuits, which are applied to the box-like body of the dashboard by insertion elements constituting a male portion of the coupling.

On the latter a female connector bearing the corresponding electric contacts is applied.

In prior art devices of the above mentioned type, the flexible electric circuit is not safely clamped in its desired position. Thus, as it would be necessary to remove the female element of the connector, then the flexible electric circuits would be displaced from their coupling seat on the dashboard box-like body with a possible damaging risk.

### SUMMARY OF THE INVENTION

Accordingly, the aim of the present invention is to overcome the above mentioned drawbacks, by providing a device for clamping a flexible circuit, specifically designed for dashboards of motor vehicle, motorcycles and the like, providing a firm and safe coupling of the flexible electric circuit, thereby allowing the female element of the connector to be easily removed without causing any displacements of other portions.

Within the scope of the above mentioned aim, a main object of the present invention is to provide such a clamping device which does not modify the conventional flexible electric circuit couplings, thereby allowing to use prior assembling apparatus.

Another object of the present invention is to provide such a clamping device which, owing to its constructional features, is very reliable and safe in operation.

Yet another object of the present invention is to provide such a clamping device which can be made starting from easily available elements and materials.

Yet another object of the present invention is to provide such a clamping device which is very competitive from a mere economic standpoint.

According to one aspect of the present invention, the above mentioned aim and objects, as well as yet other objects, which will become more apparent hereinafter, are achieved by a clamping device for clamping a flexible circuit, for motor vehicle and motorcycle dashboards, comprising, on a box-like of a dashboard, or the like, at least an insertion element which can be inserted into a corresponding hole of a flexible circuit, characterized in that said insertion element comprises a tooth element defining an abutment element which can be engaged with a face of said flexible circuit opposite to the insertion face of said tooth element.

### BRIEF DESCRIPTION OF THE DRAWINGS

Further characteristics and advantages of the present invention will become more apparent hereinafter from the following detailed disclosure of a flexible circuit clamping device, being illustrated, by way of a merely indicative, but not limitative, example, in the accompanying drawings, where:

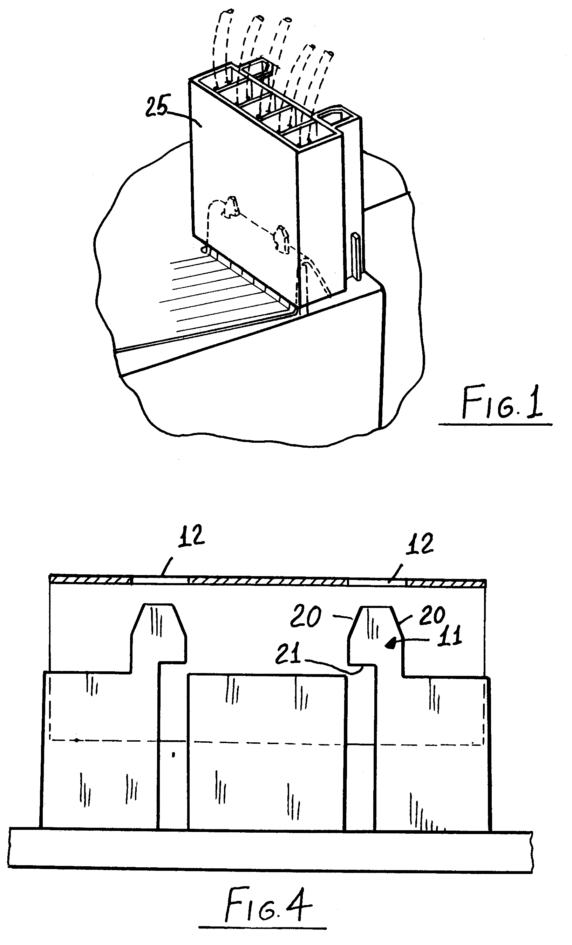

Figure 1 is a schematic perspective view illustrating a female connector coupled to a flexible circuit;

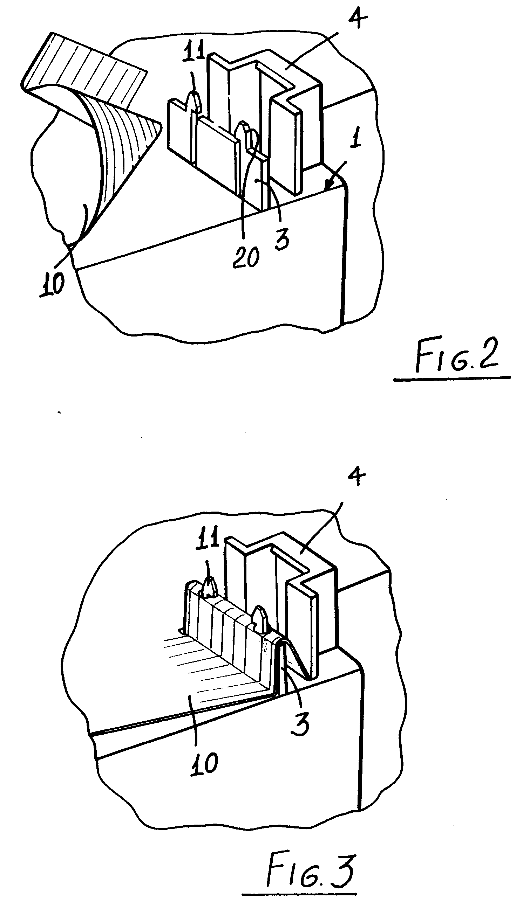

Figure 2 is a further schematic perspective view illustrating a method for coupling the flexible circuit to the male element;
Figure 3 is a further perspective view illustrating the subject flexible circuit coupled to the male element;
Figure 4 is a cross-sectional view showing the male element and the clamping device with the flexible circuit being represented in an exploded form;
Figure 5 is a schematic cross-sectional view showing the clamping device with the flexible circuit applied to the male element; and
Figure 6 is a schematic view showing a dashboard including the clamping device according to the present invention.

### DESCRIPTION OF THE PREFERRED EMBODIMENT

With reference to the number references of the above mentioned figures, the device for clamping a flexible circuit, specifically designed for application to motor vehicle, motorcycle and the like dashboards, according to the present invention, comprises, on a box-like body 1 of a dashboard 2, a male element 3 adjoining an abutment body 4, also made rigid on the box-like body.

On the male element 3 a flexible electric circuit 10 is applied, said flexible electric circuit being held by insertion elements 11, designed for insertion into holes 12 formed in said flexible circuit 10.

The main feature of the invention is that the insertion element 11 is provided with a tooth element, provided with tapered portions 20, at its free end portion, for facilitating the introduction thereof into the hole 12.

At a bottom portion thereof, said tooth element defines an abutment element 21, formed in the side portion of the tooth element.

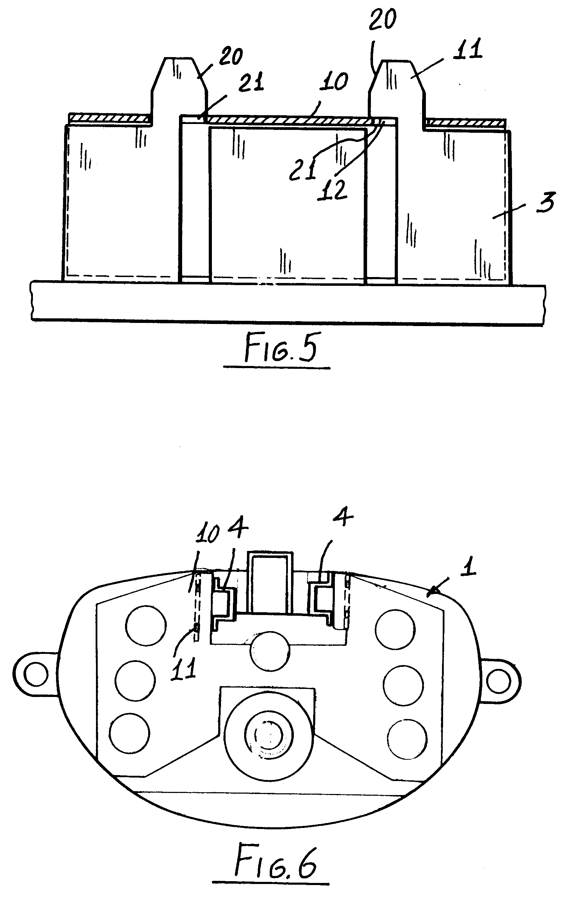

The latter has a flat configuration and is so arranged as to overlap the flexible circuit 10, as is schematically shown in Figure 5.

On the male portion 3, a female connector 25 for providing the desired electric connections is engaged.

If the connector 25 must be removed, then the flexible circuit would be not displaced, since it would be restrained by the abutment element engaging with the face of said flexible circuit opposite to the insertion face of the tooth element 11.

By the above disclosed arrangement, without modifying the conventionally used tools for applying the flexible circuit, it would be possible to provide a firm coupling of the flexible circuit to the dashboard box-like body.

Moreover it would be obtained the further advantage that, even if the female element of the connector 25 must be removed, no displacement or damaging of the flexible circuit will occur.

From the above disclosure it should be apparent that the invention fully achieves the intended aim and objects.

In particular, it is pointed out that a very simple and operationally efficient clamping device has been provided, allowing to obtain great operating advantages.

In practicing the invention, the used materials, provided that they are compatible to the intended application, as well as the contingent size and shapes could be any, depending on requirements.

## Claims

1. A clamping device for clamping a flexible circuit, for motor vehicle and motorcycle dashboards, comprising, on a box-like of a dashboard, or the like, at least an insertion element which can be inserted into a corresponding hole of a flexible circuit, characterized in that said insertion element comprises a tooth element defining an abutment element which can be engaged with a face of said flexible circuit opposite to the insertion face of said tooth element.

2. A clamping device, according to Claim 1, characterized in that said insertion element is defined on a male element, rigid with said box-like body and which can be coupled to a female element of an electric connector.

3. A clamping device, according to Claims 1 and 2, characterized in that said tooth element has a flat configuration.

4. A clamping device, according to one or more of the preceding claims, characterized in that said tooth element is provided with a tapering part at a free end portion thereof, adapted to facilitate the engagement thereof in said hole.

5. A clamping device, according to one or more of the preceding claims, characterized in that said abutment element is defined under said tapering part and is made in a side portion of said tooth element.

6. A device for clamping a flexible circuit, specifically designed for motor vehicle and motorcycle dashboards and the like, according to one or more of the preceding claims, and substantially as broadly disclosed and illustrated and for the intended aim and objects.
